# EUROPÄISCHE PATENTANMELDUNG

(11) **EP 3 826 078 A1**
(43) Veröffentlichungstag der Anmeldung: **26.05.2021**
(21) Anmeldenummer: 20000395.2
(22) Anmeldetag: 03.11.2020
(51) Int. Cl.: H01L 31/0687, H01L 31/0224, H01L 31/0216

(54) **STAPELFÖRMIGE MEHRFACHSOLARZELLE**

(30) Priorität: 21.11.2019 DE 102019008106
(71) Anmelder: AZUR SPACE Solar Power GmbH, 74072 Heilbronn (DE)
(72) Erfinder: Köstler, Wolfgang, 74074 Heilbronn (DE); Frey, Alexander, 74223 Flein (DE)
(74) Vertreter: Koch Müller Patentanwaltsgesellschaft mbH

(57) **Zusammenfassung**

Stapelförmige Mehrfachsolarzelle mit rückseitenkontaktierter Vorderseite bereitgestellt, aufweisend einen eine Ge-Substratschicht, eine Ge-Teilzelle und mindestens zwei III-V-Teilzellen umfassenden Solarzellenstapel mit einer Durchgangskontaktöffnung, einen Vorderseitenanschlusskontakt, einen Rückseitenanschlusskontakt, eine auf einem Teil der Vorderseite der Mehrfachsolarzelle ausgebildete Antireflexschicht, eine dielektrische Isolationsschicht sowie eine Kontaktschicht, wobei die dielektrische Isolationsschicht die Antireflexschicht, einen Randbereich einer Oberseite des Vorderseitenanschlusskontakts, eine Seitenfläche der Durchgangskontaktöffnung und einen an die Durchgangskontaktöffnung angrenzenden Bereich der Rückseite des Solarzellenstapels bedeckt, die Kontaktschicht sich von einen nicht von der dielektrischen Isolationsschicht bedeckten Bereich der Oberseite des Vorderseitenanschlusskontakts auf der dielektrischen Isolationsschicht durch die Durchgangskontaktöffnung bis zu Rückseite des Solarzellenstapels erstreckt und der Rückseitenanschlusskontakt einen nicht von der dielektrischen Isolationsschicht bedeckten Bereich der Rückseite des Solarzellenstapels bedeckt.

## Beschreibung

Die Erfindung betrifft eine stapelförmige Mehrfachsolarzelle.

Um die Abschattung der Vorderseite einer Solarzelle zu reduzieren, ist es möglich, sowohl die positive als auch die negative externe Kontaktfläche auf der Rückseite anzuordnen. Bei sogenannten Metal Wrap Through (MWT) - Solarzellen wird die Solarzellenvorderseite beispielsweise durch eine Durchgangskontaktöffnung von der Rückseite aus kontaktiert.

Es sind unterschiedliche Verfahren zur Herstellung eines Lochs bzw. einer Durchgangskontaktöffnung durch eine Solarzelle bekannt, welche in entsprechend unterschiedlichen Durchgangskontaktöffnungen bzw. Solarzellenstrukturen resultieren.

Aus "Die Metal Wrap Through Solarzelle - Entwicklung und Charakterisierung", F. Clement, Dissertation, Februar 2009 ist ein Herstellungsverfahren für eine MWT-einfach-Solarzelle aus multikristallinem Silizium bekannt, wobei die Durchgangskontaktöffnungen mittels eines UV-Lasers oder eines IR-Lasers in einer multikristallinen Silizium-Substratschicht erzeugt werden. Erst anschließend wird mittels Phosphordiffusion entlang der Oberseite, der Seitenflächen der Durchgangskontaktöffnung und der Unterseite der Solarzelle eine Emitterschicht erzeugt. Die Durchgangskontaktöffnung wird mit mittels Siebdrucks mit einer leitfähigen Via-Paste, z.B. einer Silberpaste, gefüllt.

Mit dem Laser kann eine sehr glatte Seitenfläche im Bereich des Durchgangslochs erreicht werden, außerdem treten bei einem Laser-Ablations-Prozess keine Hinterschneidungen auf. Das Erzeugen eines Lochs durch einen bestehenden pn-Übergang mittels Laser-Ablation würde allerdings zu Kurzschlüssen führen.

Aus "III-V multi-junction metal-wrap-through (MWT) concentrator solar cells", E. Oliva et al., Proceedings, 32nd European PV Solar Energy Conference and Exhibition, München, 2016, pp. 1367-1371, ist eine invertiert gewachsene GaInP/AlGaAs Solarzellenstruktur mit Durchgangskontaktöffnungen bekannt, wobei die Solarzellenstruktur mit den pn-Übergängen epitaktisch gewachsen wird und erst anschließend die Durchgangskontaktöffnungen mittels Trockenätzen erzeugt werden. Anschließend wird die Seitenfläche der Durchgangsöffnung mit einer Isolationsschicht beschichtet und dann die Durchgangsöffnung mit galvanisiertem Kupfer gefüllt.

Aus der US 9,680,035 B1 ist ein Solarzellenstapel aus mehreren III-V-Teilzellen auf einem GaAs-Substrat mit rückseitenkontaktierter Vorderseite bekannt, wobei ein von der Oberseite der Solarzelle durch die Teilzellen bis in eine noch nicht gedünnte Substratschicht hinein reichendes Loch mittels eines nasschemischen Ätzprozesses erzeugt wird.

Der Ätzprozess basiert darauf, dass sich die Ätzraten für die verwendeten unterschiedlichen III-V-Materialien des Solarzellenstapels nicht wesentlich unterscheiden. Das Loch wird erst durch Dünnen der Substratschicht nach unten geöffnet.

Eine Passivierung und Metallisierung der Vorderseite und des Lochs wird vor dem Dünnen der Substratschicht durchgeführt. Das nasschemische Ätzen hat im Vergleich zu entsprechenden Trockenätzprozessen den Vorteil, dass die Seitenwände des Lochs eine glattere Oberfläche aufweisen und die Passivierungsschicht konform und ohne Fehlstellen abgeschieden werden kann.

Eine Schwierigkeit besteht darin, dass für jeden Maskenprozess, der nach dem Herstellen der Durchgangslöcher durchgeführt wird, ein größerer Aufwand zum Schutz bzw. der Versiegelung der Durchgangsöffnungen notwendig ist.

Vor diesem Hintergrund besteht die Aufgabe der Erfindung darin, eine Vorrichtung anzugeben, die den Stand der Technik weiterbildet.

Die Aufgabe wird durch eine stapelförmige Mehrfachsolarzelle mit den Merkmalen des Patentanspruchs 1 und durch ein Herstellungsverfahren für eine stapelförmige Mehrfachsolarzelle gemäß dem Patentanspruch 9 gelöst. Vorteilhafte Ausgestaltungen der Erfindung sind Gegenstand von Unteransprüchen.

Gemäß dem Gegenstand der Erfindung wird eine stapelförmige Mehrfachsolarzelle mit rückseitenkontaktierter Vorderseite bereitgestellt, aufweisend einen Solarzellenstapel mit einer Vorderseite, einer Rückseite und einer sich von der Vorderseite bis zu der Rückseite des Solarzellenstapels erstreckenden Durchgangskontaktöffnung.

Die stapelförmige Mehrfachsolarzelle weist außerdem einen Vorderseitenanschlusskontakt, einen Rückseitenanschlusskontakt, eine dielektrische Isolationsschicht sowie eine Kontaktschicht auf.

Der Solarzellenstapel weist in der genannten Reihenfolge aufeinanderfolgend eine die Rückseite ausbildende Germanium-Substratschicht, eine Germanium-Teilzelle und mindestens zwei III-V-Teilzellen auf und die Durchgangskontaktöffnung weist eine zusammenhängende Seitenfläche und in einem Querschnitt einen ovalen Umfang auf.

Der Vorderseitenanschlusskontakt ist auf der Vorderseite des Solarzellenstapels angeordnet und mit der Vorderseite des Solarzellenstapels stoffschlüssig und elektrisch leitfähig verbunden.

Die dielektrische Isolationsschicht bedeckt einen nicht von dem Vorderseitenanschluss bedeckten Bereich der Vorderseite des Solarzellenstapels, einen Randbereich einer Oberseite des Vorderseitenanschlusskontakts, die Seitenfläche der Durchgangskontaktöffnung und einen an die Durchgangskontaktöffnung angrenzenden Bereich der Rückseite des Solarzellenstapels.

Die Kontaktschicht erstreckt sich von einem nicht von der dielektrischen Isolationsschicht bedeckten Bereich der Oberseite des Vorderseitenanschlusskontakts auf der dielektrischen Isolationsschicht durch die Durchgangskontaktöffnung bis zu Rückseite des Solarzellenstapels und ist stoffschlüssig und elektrisch leitfähig mit der Oberseite des Vorderseitenanschlusskontakts sowie stoffschlüssig mit der dielektrischen Isolationsschicht verbunden.

Der Rückseitenanschlusskontakt bedeckt einen nicht von der dielektrischen Isolationsschicht bedeckten Bereich der Rückseite des Solarzellenstapels und ist mit der Rückseite des Solarzellenstapels stoffschlüssig und elektrisch leitfähig verbunden.

Es versteht sich, dass die einzelnen Teilzellen der Mehrfachsolarzelle jeweils einen pn-Übergang aufweisen und die auf das Substrat folgenden Schichten epitaktisch aufeinander erzeugt und/oder mittels Wafer-Bond miteinander verbunden sind.

Außerdem versteht es sich, dass eine Germanium-Teilzelle Germanium aufweist oder aus Germanium besteht, wobei auch eine aus Germanium bestehende Schicht gegebenenfalls zusätzlich zu dem Germanium noch weitere Stoffe, insbesondere Dotierstoffe, aber auch Verunreinigungen enthält.

Entsprechendes gilt auch für die III-V-Teilzellen, welche ein oder mehrere Materialien der III. sowie der V. Hauptgruppe aufweisen oder aus solchen Materialien bzw. einer solchen Materialkombination bestehen.

Ein Vorteil der erfindungsgemäßen Mehrfachsolarzelle ist, dass zumindest die Vorderseitenanschlusskontakte vor dem Erzeugen der Durchgangskontaktöffnungen herstellbar sind, d.h. die Vorderseite kann unter Verwendung von Standardprozessen fertig prozessiert werden.

Ein weiterer Vorteil der erfindungsgemäßen Mehrfachsolarzelle ist, dass die dielektrische Schicht die Vorderseite der Solarzelle fast ganzflächig bedeckt und die Mehrfachsolarzelle vor schädlichen Umwelteinflüssen schützt.

Ein anderer Vorteil der erfindungsgemäßen Mehrfachsolarzelle ist entsprechend eine hohe Zuverlässigkeit und Güte.

Gemäß einer ersten alternativen Ausführungsform ist die dielektrische Isolationsschicht als eine Antireflexschicht ausgebildet. Die dielektrische Isolationsschicht weist also zusätzlich zu der isolierenden Funktion auch die Funktion auf, Reflexionen zu unterdrücken und die Transmission zu erhöhen. Eine zusätzliche Antireflexschicht ist nicht mehr notwendig.

Gemäß einer anderen alternativen Ausführungsform weist die Mehrfachsolarzelle eine zwischen der dielektrischen Isolationsschicht und dem Solarzellenstapel angeordnete Antireflexschicht auf, wobei die Antireflexschicht den nicht von dem Vorderseitenanschluss bedeckten Bereich der Vorderseite des Solarzellenstapels bedeckt.

Eine zusätzliche Antireflexschicht bedeutet zwar einen zusätzlichen Herstellungsschritt, dafür ist man hinsichtlich der Wahl der Materialien für die Antireflexschicht freier. Außerdem kann eine einfachere Struktur für die dielektrische Isolationsschicht gewählt werden, insbesondere kann die Isolationsschicht als eine einzige Schicht ausgebildet werden.

Die Antireflexschicht bedeckt gemäß einer Weiterbildung den Randbereich der Oberseite des Vorderseitenanschlusskontakts. In einer anderen Weiterbildung ist die Antireflexschicht elektrisch leitfähig.

Ob die Antireflexschicht den Randbereich des Vorderseitenanschlusskontakts bedeckt oder nicht, richtet sich im Wesentlichen nach dem Herstellungsprozess.

Gemäß einer weiteren Ausführungsform weist die dielektrische Isolationsschicht TiO und/oder MgF₂ und/oder Al₂O₃ und/oder SiO₂ und/oder Si₃N₄ und/oder Ta₂O₅ und/oder ZrO₂ auf. Die genannten Materialien eignen sich sowohl, um die Funktion der elektrischen Isolation sicherzustellen, als auch um eine Reflexionen entgegenwirkende bzw. unterdrückende Struktur auszubilden.

In einer Weiterbildung weist der Vorderseitenanschlusskontakt eine stoffschlüssig mit der Vorderseite des Solarzellenstapels verbundene hochdotierte Halbleiterkontaktschicht und eine stoffschlüssig mit der Halbleiterkontaktschicht verbundene Metallschicht auf.

In einer Ausführungsform weisen die III-V-Teilzellen eine gemeinsame Schichtdicke von 5 - 15 µm auf.

In einer anderen Ausführungsform weist die Durchgangskontaktöffnung an der Vorderseite der Mehrfachsolarzelle einen ersten Durchmesser von mindestens 50 µm oder mindestens 100 µm oder mindestens 300 µm auf, wobei der erste Durchmesser nicht größer als 1 mm ist.

Gemäß einer anderen Weiterbildung nimmt ein Durchmesser der Durchgangskontaktöffnung von der Vorderseite zu der Rückseite der Mehrfachsolarzelle hin stufenförmig ab, wobei eine erste Stufe von einer Oberseite der Ge-Teilzelle und eine zweite Stufe von einem unterhalb eines pn-Übergangs der Germanium-Teilzelle befindlichen Bereich der Germanium-Teilzelle ausgebildet ist und jede Stufe jeweils mit einer Auftrittstiefe umlaufend in die Durchgangskontaktöffnung hineinragt.

Gemäß einer weiteren Ausführungsform beträgt die Auftrittstiefe der ersten Stufe mindestens 5 µm und/oder die Auftrittstiefe der zweiten Stufe mindestens 6 µm oder mindestens 7 µm. In einer Weiterbildung beträgt die Auftrittstiefe der ersten Stufe maximal 100 µm und oder die Auftrittstiefe der zweiten Stufe maximal 500 µm.

In einer anderen Ausführungsform weist die Germanium-Teilzelle zusammen mit dem Germanium-Substrat eine Schichtdicke von 80 - 300 µm oder von 140 - 160 µm oder von 80 - 120 µm auf.

Gemäß einer anderen Weiterbildung ist die Kontaktschicht als Mehrschichtsystem in der genannten Reihenfolge umfassend eine Gold und Germanium umfassende erste Schicht mit einer Schichtdicke von mindestens 2 nm und höchstens 50 nm, eine Titan umfassende zweite Schicht mit einer Schichtdicke von mindestens 10 nm und höchstens 300 nm, eine Palladium oder Nickel oder Platin umfassende dritte Schicht mit einer Schichtdicke von mindestens 5 nm und höchstens 300 nm und mindestens eine metallische vierte Schicht mit einer Schichtdicke von mindestens 2 µm ausgebildet.

Hierbei grenzt die erste Schicht an die dielektrische Isolationsschicht und den Vorderseftenanschlusskontakt an.

Die erfindungsgemäße Kombination von Schichten stellt einen zuverlässigen Stoffschluss mit der Oberseite des Vorderseitenanschlusskontakts sowie mit der Oberfläche der dielektrischen Isolationsschicht sicher.

Gemäß dem weiteren Gegenstand der Erfindung wird ein Herstellungsverfahren für eine stapelförmige Mehrfachsolarzelle mit rückseitenkontaktierter Vorderseite bereitgestellt, mindestens umfassend die Schritte:
- Bereitstellen einer Halbleiterscheibe mit einer Oberseite, einer Unterseite und umfassend mehrere Solarzellenstapel, wobei jeder Solarzellenstapel ein die Unterseite der Halbleiterscheibe ausbildendes Ge-Substrat, eine Ge-Teilzelle und mindestens zwei III-V-Teilzellen in der genannten Reihenfolge aufeinanderfolgen aufweist,
- Aufbringen eines Vorderseitenanschlusskontakts auf der Oberseite der Halbleiterscheibe je Solarzellenstapel,
- Herstellen eines von einer Oberseite der Halbleiterscheibe zumindest bis über einen pn-Übergang der Ge-Teilzelle in die Halbleiterscheibe hineinreichenden Grabens mit zusammenhängender Seitenwand und einem im Querschnitt ovalen Umfang in einem Abstand zu dem Vorderseitenanschlusskontakt je Solarzellenstapel,
- Herstellen eines von einem Boden des Grabens bis zu der Unterseite der Halbleiterscheibe reichenden Durchgangslochs mit zusammenhängender Seitenwand und einem im Querschnitt ovalen Umfang je Solarzellenstapel,
- Aufbringen einer dielektrischen Isolationsschicht entlang der Vorderseite der Halbleiterscheibe, der Rückseite der Halbleiterscheibe und auf der Seltenwand des Grabens sowie der Seitenwand des Durchgangslochs,
- Entfernen der Isolationsschicht auf einem Teil der Oberseite des Vorderseitenanschlusskontakts je Solarzellenstapel,
- Aufbringen einer von der freigelegten Oberseite des Vorderseitenanschlusskontakts über die dielektrische Isolationsschicht durch den Graben und das Durchgangsloch bis auf einen an das Durchgangsloch angrenzenden mit der dielektrischen Isolationsschicht beschichteten Bereich der Rückseite der Halbleiterscheibe reichenden Kontaktschicht je Solarzellenstapel.
- Je Solarzellenstapel wird ein Rückseitenanschlusskontakt zu einem Zeitpunkt vor dem Aufbringen der dielektrischen Schicht auf der Rückseite der Halbleiterscheibe angeordnet und zu einem Zeitpunkt nach dem Aufbringen der dielektrischen Isolationsschicht wird die dielektrische Isolationsschicht auf einem Teil einer Oberseite des Rückseitenanschlusskontakts entfernt.
- Alternativ wird je Solarzellenstapel zu einem Zeitpunkt nach dem Aufbringen der dielektrischen Isolationsschicht die dielektrische Isolationsschicht von einem Oberflächenabschnitt der Rückseite der Halbleiterscheibe entfernt und zu einem nachfolgenden Zeitpunkt ein Rückseitenanschlusskontakt auf den freigelegten Oberflächenabschnitt der Rückseite der Halbleiterscheibe aufgebracht.

Es versteht sich, dass zusätzlich zu dem Vorderseitenanschlusskontakt gegebenenfalls noch weitere Kontaktstrukturen auf der Vorderseite angeordnet werden, wobei gegebenenfalls kein Oberflächenbereich der zusätzlichen Kontaktstrukturen freigelegt wird.

Die dielektrische Isolationsschicht, z.B. Si0₂ und/oder SiNₓ(Si-Nitrid), lässt sich auf einfache Weise ganzflächig auf Vorder- und Rückseite aufbringen, beispielsweise mittels Plasma-unterstützter chemischer Gasphasenabscheidung (PECVD).

Außerdem muss die dielektrische Schicht gemäß dem erfindungsgemäßen Verfahren nicht großflächig strukturiert werden. Lediglich in einem Bereich oberhalb der Vorderseitenanschlusskontakte wird die aufgebrachte dielektrische Isolationsschicht entfernt bzw. geöffnet.

Die dielektrische Isolationsschicht lässt sich mittels eines Ätzschritts und oder mittels eines Lasers durchführen. Das Entfernen mittels Laser hat den Vorteil, dass typische Ätzschäden, wie Pinholes vermieden werden. Das erfindungsgemäße Verfahren stellt dadurch eine hohe Zuverlässigkeit und Güte der hergestellten Zellen sicher. Außerdem können Flusssäure-Prozesse vermieden und dadurch die Umwelt geschont und die Arbeitssicherheit erhöht werden.

Gemäß einer ersten Weiterbildung wird vor dem Herstellen des Grabens eine Antireflexschicht auf einen nicht von den Vorderseitenanschlusskontakten bedeckten Teil der Oberseite der Halbleiterscheibe aufgebracht, wobei nach dem Entfernen der Isolationsschicht auf einem Teil einer Oberseite des Vorderseitenanschlusskontakts je Solarzellenstapel auch die Antireflexschicht von dem Teil der Oberseite des Vorderseitenanschlusskontakts entfernt wird. Das Entfernen von Isolationsschicht und Antireflexschicht wird gemäß einer Weiterbildung in demselben Prozessschritt durchgeführt.

Gemäß einer alternativen Weiterbildung wird die dielektrische Isolationsschicht als Antireflexschicht ausgebildet. Beispielsweise wird eine Isolationsschicht mit einer mindestens eine Schicht umfassenden Schichtstruktur aus TiO und/oder MgF₂ und/oder Al₂O₃ und/oder SiO₂ und/oder Si₃N₄ und/oder Ta₂O₅ und/oder ZrO₂ aufgebracht, welche sowohl die Funktion der elektrischen Isolation als auch die Funktion der Reflexionsunterdrückung erfüllt.

Gemäß einer Ausführungsform wird die dielektrische Isolationsschicht mit einer an die Antireflexschicht angepassten Transparenz und einem an die Antireflexschicht angepassten Brechungsindex abgeschieden. Transparenz und Brechungsindex entsprechen beispielsweise einem später aufzubringenden Deckglas und dem hierfür verwendeten Silikonkleber.

Ein Vorteil des erfindungsgemäßen Verfahrens ist die vereinfachte Prozessführung mit nur wenigen Prozessschritten. Insbesondere photolithographische und nasschemische Ätz-Schritte erübrigen sich.

Hierdurch stellt das erfindungsgemäße Verfahren ein besonders einfaches und kostengünstiges Herstellungsverfahren dar.

Außerdem schützt die auf der Oberseite der Mehrfachsolarzelle flächig verbleibende dielektrische Isolationsschicht die Zelle vor schädlichen Umwelteinflüssen.

In einer Weiterbildung werden als Vorderseitenanschlusskontakt zuerst eine hochdotierte Halbleiterkontaktschicht auf der Vorderseite der Halbleiterscheibe und anschließend eine Metallschicht auf einer Oberseite der hochdotierten Halbleiterkontaktschicht aufgebracht.

In einer weiteren Ausführungsform wird der Vorderseitenanschlusskontakt mittels mindestens eines Maskenprozesses aufgebracht.

Gemäß einer anderen Weiterbildung wird der Graben mittels eines Ätzprozesses erzeugt, wobei der Ätzprozess zur Herstellung des Grabens gemäß einer weiteren Weiterbildung zwei Ätzschritte, z.B. einen selektiv das Material der III-V-Teilzellen ätzenden Teilschritt und einen auch das Germanium ätzenden Teilschritt, umfasst.

In einer anderen Ausführungsform wird der Graben mittels eines Laserablationsprozesses erzeugt. Mittels der Laserablation wird auf relativ schnelle und einfache Art eine Öffnung mit einer glatten Seitenfläche erzeugt.

Die Kombination eines Ätzprozesses zur Erzeugung eines sich über alle pn-Übergänge erstreckenden Grabens mit einem Laserablationsprozess ermöglicht ein schnelles Erzeugen eines Durchgangslochs auch durch noch ungedünnte Substratschichten und verhindert gleichzeitig Kurzschlüsse im Bereich der pn-Übergänge durch den Energieeintrag des Lasers.

In anderen Ausführungsformen wird die dielektrische Isolationsschicht von der Oberselte des Vorderseitenanschlusskontakts und/oder von der Unterseite der Halbleiterscheibe mittels eines Laserablationsprozesses oder mittels eines Ätzprozesses entfernt.

In einer anderen Weiterbildung wird nach dem Herstellen des Grabens oder nach dem Herstellen des Durchgangslochs das Ge-Substrat von der Rückseite der Halbleiterscheibe gedünnt. Wird das Substrat nach dem Grabenätzen und vor dem Lasern des Durchgangslochs gedünnt, so wird der Laser-Ablationsprozess beschleunigt bzw. verkürzt.

Ein Dünnen nach dem Laser-Ablationsprozess verlängert diesen zwar, erhöht aber die Stabilität während gegebenenfalls durchzuführender weiterer Prozessschritte, was zu weniger Bruch und damit zu einer besseren Ausbeute führt.

Das Dünnen wird beispielsweise ganzflächig oder alternativ mittels des sogenannten TAIKO Verfahrens durchgeführt.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die laterale und vertikale Erstreckung sind nicht maßstäblich und weisen, sofern nicht anders angegeben, auch keine ableitbaren geometrischen Relationen zueinander auf. Darin zeigen, die
- Figur 1A: einen Querschnitt einer ersten erfindungsgemäßen Ausführungsform einer stapelförmigen Mehrfachsolarzelle mit rückseitenkontaktierter Vorderseite,
- Figur 1B: einen Querschnitt einer weiteren erfindungsgemäßen Ausführungsform der stapelförmigen Mehrfachsolarzelle mit rückseitenkontaktierter Vorderseite,
- Figur 1C: einen Querschnitt einer weiteren erfindungsgemäßen Ausführungsform der stapelförmigen Mehrfachsolarzelle mit rückseitenkontaktierter Vorderseite,
- Figur 2: eine Aufsicht auf eine erfindungsgemäße Ausführungsform der Mehrfachsolarzelle,
- Figur 3: eine Rückseite einer erfindungsgemäßen Ausführungsform der Mehrfachsolarzelle,
- Figur 4: eine Aufsicht auf eine Halbleiterscheibe umfassend eine Vielzahl von stapelförmigen Mehrfachsolarzellen,
- Figur 5: einen Ablauf eines Herstellungsverfahrens gemäß einer ersten erfindungsgemäßen Ausführungsform,
- Figur 6: weitere Verfahrensschritte eines Herstellungsverfahrens gemäß einer erfindungsgemäßen Ausführungsform.

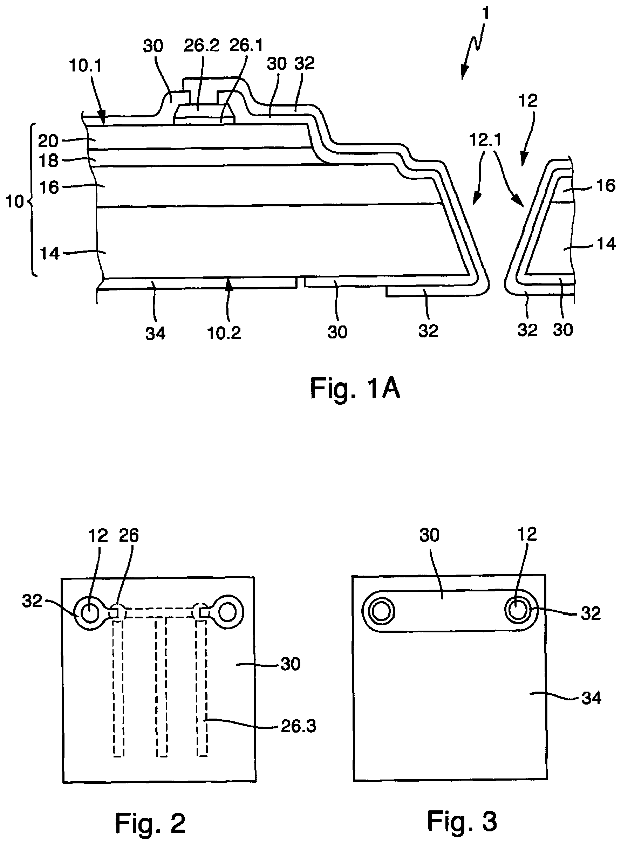

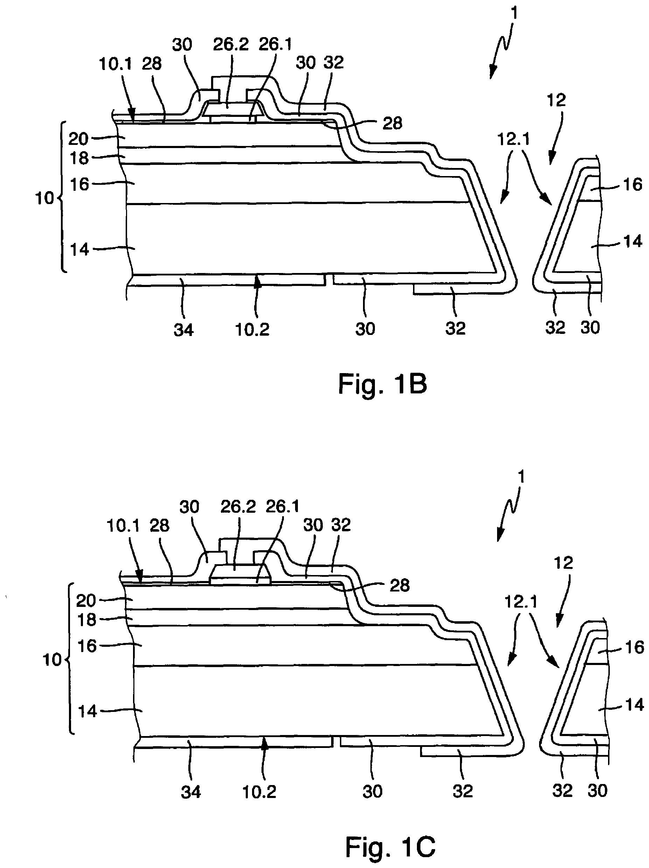

Die Abbildung der Figur 1 zeigt einen Ausschnitt einer ersten erfindungsgemäßen Ausführungsform einer stapelförmigen Mehrfachsolarzelle 1 mit rückseitenkontaktierter Vorderseite in einem Querschnitt.

Die stapelförmige Mehrfachsolarzelle weist einen Solarzellenstapel 10 mit einer Vorderseite 10.1, einer Rückseite 10.2 und einer sich von der Vorderseite 10.1 bis zu der Rückseite 10.2 des Solarzellenstapels 10 erstreckenden Durchgangskontaktöffnung 12 auf. Der Solarzellenstapel 10 weist in der genannten Reihenfolge aufeinanderfolgend eine die Rückseite 10.2 ausbildende Germanium-Substratschicht 14, eine Germanium-Tellzelle 16 und zwei III-V-Teilzellen 18 und 20 auf. Die Durchgangskontaktöffnung 12 weist eine zusammenhängende Seitenfläche 12.1 und in einem Querschnitt einen ovalen Umfang auf.

Außerdem weist die stapelförmige Mehrfachsolarzelle einen Vorderseitenanschlusskontakt 26, einen Rückseitenanschlusskontakt 34, eine dielektrische Isolationsschicht 30 sowie eine Kontaktschicht 32.

Der Vorderseltenanschlusskontakt 26 besteht aus einer auf einem Bereich der Vorderseite 10.1 des Solarzellenstapels 10 angeordnete und mit der Vorderseite 10.1 des Solarzellenstapels 10 stoffschlüssig verbundenen hochdotierten Halbleiterkontaktschicht 26.1 und einer stoffschlüssig mit der Halbleiterkontaktschicht 26.1 verbundenen Metallschicht 26.2.

Der Rückseitenanschlusskontakt 34 bedeckt einen Bereich der Rückseite 10.2 des Solarzellenstapels 10 und ist mit der Rückseite 10.2 des Solarzellenstapels 10 in dem bedeckten Bereich stoffschlüssig verbunden.

Die dielektrische Isolationsschicht 30 bedeckt einen nicht von dem Vorderseitenanschluss 26 bedeckten Bereich der Vorderseite 10.1 des Solarzellenstapels 10, einen Randbereich einer Oberseite des Vorderseitenanschlusskontakts 26, die Seitenfläche 12.1 der Durchgangskontaktöffnung 12 und einen an die Durchgangskontaktöffnung 12 angrenzenden Bereich der Rückseite 10.2 des Solarzellenstapels 10, so dass in einer Projektion senkrecht zu der Vorderseite 10.1 des Solarzellenstapels lediglich ein zentraler Bereich des Vorderseitenanschlusskontakts 26 nicht von der Isolationsschicht 30 bedeckt ist. In einer Projektion senkrecht zu der Rückseite 10.2 des Solarzellenstapels umgibt die Isolationsschicht 30 die Durchgangskontaktöffnung und reicht höchstens bis zu dem Rückseitenanschlusskontakt 34.

Die Kontaktschicht 32 erstreckt sich von einen nicht von der dielektrischen Isolationsschicht 30 bedeckten Bereich der Oberseite des Vorderseitenanschlusskontakts 26 auf der dielektrischen Isolationsschicht 30 durch die Durchgangskontaktöffnung 12 bis zu Rückseite 10.2 des Solarzellenstapels 10 und ermöglicht so das Kontaktieren des Vorderseitenanschlusskontakts 26 auf der Rückseite 10.2 des Solarzellestapels. Die Kontaktschicht 32 ist stoffschlüssig und elektrisch leitfähig mit der Oberseite des Vorderseitenanschlusskontakts 26 und stoffschlüssig mit der dielektrischen Isolationsschicht 30 verbunden.

Gemäß einer Weiterbildung ist die dielektrische Isolationsschicht 30 als Antireflexschicht ausgebildet, d.h. die Isolationsschicht 30 weist dielektrische bzw. elektrisch isolierende Materialien und eine Reflexionen unterdrückende Struktur auf.

In der Abbildung der Figur 1B ist ein Querschnitt einer alternativen Ausführungsform einer stapelförmigen Mehrfachsolarzelle 1 dargestellt, wobei im Folgenden nur die Unterschiede zu der Abbildung der Figur 1A erläutert werden.

Die Mehrfachsolarzelle 1 weist eine Antireflexschicht 28 auf, wobei die Antireflexschicht 28 zwischen dem Solarzellenstapel 10 und der dielektrischen Isolationsschicht 30 angeordnet ist.

Die Antireflexschicht 28 bedeckt einen nicht von dem Vorderseitenanschluss 26 bedeckten Bereich der Vorderseite 10.1 des Solarzellenstapels 10 und den Randbereich des Vorderseitenanschlusskontakts 26 und reicht bis zu einem Rand der Durchgangskontaktöffnung 12. Die dielektrische Isolationsschicht 30 bedeckt die Antireflexschicht 28 im dargestellten Ausführungsbeispiel vollständig.

In der Abbildung der Figur 1C ist ein Querschnitt einer weiteren alternativen Ausführungsform einer stapelförmigen Mehrfachsolarzelle 1 dargestellt, wobei im Folgenden nur die Unterschiede zu der Abbildung der Figur 1A und 1B erläutert werden.

Die Antireflexschicht 28 bedeckt die Vorderseite 10.1 des Solarzellenstapels 10 und grenzt an den Vorderseitenanschlusskontakt 26 an, so dass die Antireflexschicht in einer Projektion senkrecht zu der Vorderseite 10.1 des Solarzellenstapels den Vorderseitenanschlusskontakt umschließt und bis zu einem Rand der Durchgangskontaktöffnung 12 reicht.

In der Abbildung der Figur 2 ist eine Aufsicht auf eine erfindungsgemäße Ausführungsform einer stapelförmigen Mehrfachsolarzelle 1 dargestellt. Im Folgenden werden nur die Unterschiede zu der Abbildung der Figur 1 erläutert.

Die stapelförmige Mehrfachsolarzelle 1 weist zwei Durchgangskontaktöffnungen 12, zwei Vorderseitenanschlusskontakte 26 und eine Vorderseitenkontaktstruktur 26.3 mit einem die zwei Vorderseitenanschlusskontakte 26 verbindenden Kontaktsteg und mehreren von dem Kontaktsteg ausgehenden Kontaktfingern auf. Es versteht sich, dass auch nur 1 oder mehr als zwei Durchgangsöffnungen ausgebildet sind.

Die Kontaktschicht 32 bedeckt jeweils einen an die Durchgangskontaktöffnungen 12 angrenzenden Oberflächenbereich und erstreckt sich jeweils bis zu einem freiliegenden mittleren Bereich der Vorderseitenanschlusskontakte 26.

Ein restlicher Bereich der Vorderseite 10.1, insbesondere auch die Vorderseitenkontaktstruktur 26.3 ist von der dielektrischen Isolationsschicht 30 bedeckt.

In der Abbildung der Figur 3 ist eine Aufsicht auf eine erfindungsgemäße Ausführungsform einer stapelförmigen Mehrfachsolarzelle 1 dargestellt. Im Folgenden werden nur die Unterschiede zu der Abbildung der Figur 1 und der Figur 2 erläutert.

Auf der Rückseite 10.2 des Solarzellenstapels ist ein an die beiden Durchgangskontaktöffnungen 12 angrenzender Bereich der Rückseite 10.2 von der Kontaktschicht 32 umgeben. Ein beiden Durchgangskontaktöffnungen 12 und die von der Kontaktschicht 32 bedeckten Randbereiche umgebender Bereich der Rückseite 10.2 ist von der dielektrischen Isolationsschicht 30 bedeckt. Ein restlicher Bereich der Oberfläche der Rückseite 10.2 des Solarzellenstapels 1 ist von dem Rückseitenanschlusskontakt 34 bedeckt.

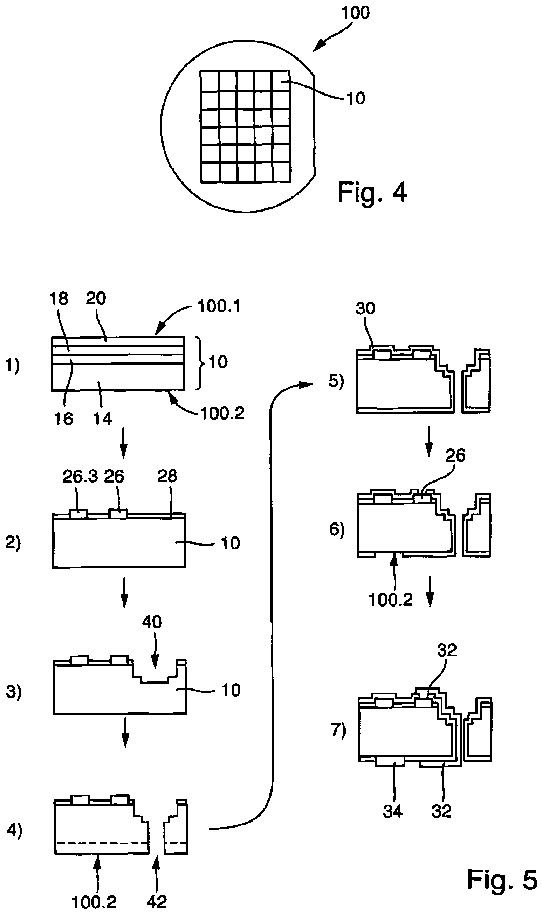

In der Abbildung der Figur 4 ist eine Aufsicht auf eine erfindungsgemäße Ausführungsform einer mehrere stapelförmige Mehrfachsolarzellen 1 umfassenden Halbleiterscheibe 100 dargestellt. Im Folgenden werden nur die Unterschiede zu der Abbildung der Figur 1 erläutert.

Die Halbleiterscheibe 100 umfasst mehrere noch nicht vereinzelte Solarzellenstapel 1, so dass die Rückseiten 10.2 der einzelnen Solarzellenstapel 1 jeweils einen Teil einer Unterseite der Halbleiterscheibe 100 und die Oberseiten 10.1 der einzelnen Solarzellenstapel 1 jeweils einen Teil einer Oberseite der Halbleiterscheibe 100 ausbilden.

In der Abbildung der Figur 5 ist eine erste erfindungsgemäße Ausführungsform eines Ablaufs eines Herstellungsverfahrens einer stapelförmigen Mehrfachsolarzelle 1 dargestellt.

In einem ersten Verfahrensschritt wird eine Halbleiterscheibe 100 mit einer Oberseite 100.1 und einer Unterseite 100.2 bereitgestellt, wobei die Halbleiterscheibe 100 mehrere Solarzellenstapel 10 umfasst und jeder Solarzellenstapel 10 ein die Unterseite 100.2 der Halbleiterscheibe 100 ausbildendes Ge-Substrat 14, eine Ge-Teilzelle 16 und zwei III-V-Teilzellen 18 und 20 in der genannten Reihenfolge aufeinanderfolgen aufweist.

In einem zweiten Verfahrensschritt wird auf der Oberseite 100.1 der Halbleiterscheibe 100 je Solarzellenstapel 10 ein Vorderseitenanschlusskontakt 26 und eine Vorderseitenkontaktstruktur 26.3, z.B. mittels eines Maskenprozesses, aufgebracht.

Außerdem wird eine Antireflexschicht 28 auf einem nicht von den Vorderseitenanschlusskontakten 26 und nicht von der Vorderseitenkontaktstruktur 26.3 bedeckten Teil der Oberseite 100.1 der Halbleiterscheibe 100, z.B. mittels eines Maskenprozesses gleichzeitig für alle Solarzellenstapel der Halbleiterscheibe 100, aufgebracht.

Anschließend wird in einem dritten Verfahrensschritt je Solarzellenstapel 10 ein von einer Oberseite der Antireflexschicht 28 zumindest bis über einen pn-Übergang der Ge-Teilzelle in die Halbleiterscheibe hineinreichenden Grabens 40 mit zusammenhängender Seitenwand und einem im Querschnitt ovalen Umfang in einem Abstand zu dem Vorderseitenanschlusskontakt 26, z.B. mittels eines Ätzprozesses gleichzeitig für alle Solarzellenstapel der Halbleiterscheibe 100 oder mittels Laserablation gleichzeitig für alle oder einige der Solarzellenstapel oder nacheinander für die einzelnen Solarzellenstapel, hergestellt.

In einem vierten Verfahrensschritt wird gleichzeitig oder nacheinander je Solarzellenstapel 10 ein von einem Boden des Grabens 40 bis zu der Unterseite 100.2 der Halbleiterscheibe 100 reichendes Durchgangslochs 42 mit zusammenhängender Seitenwand und einem im Querschnitt ovalen Umfang 12 beispielsweise ebenfalls mittels eines Ätzprozesses oder mittels Laserablation hergestellt.

In einem fünften Verfahrensschritt wird eine dielektrischen Isolationsschicht 30 entlang der Vorderseite 100.1 der Halbleiterscheibe 100, der Rückseite 100.2 der Halbleiterscheibe und auf der Seitenwand jedes Grabens 40 sowie der Seitenwand jedes Durchgangslochs 42, z.B. mittels PECVD, aufgebracht.

In einem sechsten Verfahrensschritt wird die Isolationsschicht 30 auf einem Teil einer Oberseite jedes Vorderseitenanschlusskontakts 26 sowie von einem jeweils zu dem Durchgangsloch 42 beabstandeten Bereich der Unterseite 100.2 je Solarzellenstapel entfernt. In einer Ausführungsform lässt sich in dem sechsten Verfahrensschritt auch die ARC mitentfernen.

In einem siebten Verfahrensschritt wird je Solarzellenstapel 10 eine von der freigelegten Oberseite des Vorderseitenanschlusskontakts 26 über die dielektrische Isolationsschicht 30 durch den Graben 40 und das Durchgangsloch 42 bis auf einen an das Durchgangsloch 42 angrenzenden und mit der dielektrischen Isolationsschicht 30 beschichteten Bereich der Rückseite 100.2 der Halbleiterscheibe 100 reichende Kontaktschicht aufgebracht. Außerdem wird je Solarzellenstapel ein Rückseitenanschlusskontakt 34 auf dem durch Entfernen der dielektrischen Isolationsschicht 30 freigelegten Bereich der Rückseite 100.2 der Halbleiterscheibe 100 angeordnet.

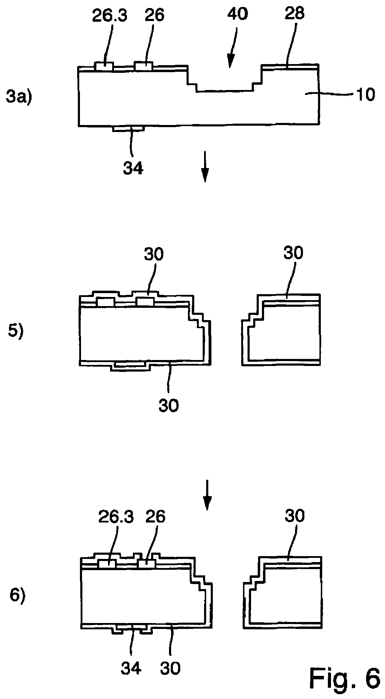

In der Abbildung der Figur 6 ist eine weitere Ausführungsform des erfindungsgemäßen Herstellungsverfahrens einer stapelförmigen Mehrfachsolarzelle 1 dargestellt. Im Folgenden werden nur die Unterschiede zu der Abbildung der Figur 5 erläutert.

Der Rückseitenanschlusskontakt 34 wird im Rahmen des dritten Verfahrensschritts, also vor, nach oder während des Anordnens des Vorderseitenkontaktanschlusses 26 und/oder des Herstellens des Grabens 40 auf einem zu dem später herzustellenden Durchgangsloch 42 beabstandeten Bereich der Rückseite 100.2 der Halbleiterscheibe 100 angeordnet.

In einem fünften Verfahrensschritt wird die dielektrische Isolationsschicht 30 auch auf einer Oberseite des Rückseitenanschlusskontakts 34 aufgebracht und im Rahmen des sechsten Verfahrensschritts von einem Bereich der Oberseite des Rückseitenanschlusskontakts 34 wieder entfernt.

## Patentansprüche

1. Stapelförmige Mehrfachsolarzelle (1) mit rückseitenkontaktierter Vorderseite, aufweisend
- einen Solarzellenstapel (10) mit einer Vorderseite (10.1), einer Rückseite (10.2) und einer sich von der Vorderseite (10.1) bis zu der Rückseite (10.2) des Solarzellenstapels (10) erstreckenden Durchgangskontaktöffhung (12),
- einen Vorderseitenanschlusskontakt (26), einen Rückseitenanschlusskontakt (34), eine dielektrische Isolationsschicht (30) sowie eine Kontaktschicht (32), wobei
- der Solarzellenstapel (10) in der genannten Reihenfolge aufeinanderfolgend eine die Rückseite (10.2) ausbildende Germanium-Substratschicht (14), eine Germanium-Teilzelle (16) und mindestens zwei III-V-Teilzellen (18, 20) aufweist,
- die Durchgangskontaktöffnung (12) eine zusammenhängende Seitenfläche und in einem Querschnitt einen ovalen Umfang aufweist,
- der Vorderseitenanschlusskontakt (26) auf der Vorderseite (10.1) des Solarzellenstapels (10) angeordnet und mit der Vorderseite (10.1) des Solarzellenstapels (10) stoffschlüssig und elektrisch leitfähig verbunden ist,
- die dielektrische Isolationsschicht (30) einen nicht von dem Vorderseitenanschlusskontakt (26) bedeckten Bereich der Vorderseite (10.1) des Solarzellenstapels (10), einen Randbereich einer Oberseite des Vorderseitenanschlusskontakts (26), die Seitenfläche (12.1) der Durchgangskontaktöffnung (12) und einen an die Durchgangskontaktöffnung (12) angrenzenden Bereich der Rückseite (10.2) des Solarzellenstapels (10) bedeckt,
- die Kontaktschicht (32) sich von einem nicht von der dielektrischen Isolationsschicht (30) bedeckten Bereich der Oberseite des Vorderseitenanschlusskontakts (26) auf der dielektrischen Isolationsschicht (30) durch die Durchgangskontaktöffnung (12) bis zu Rückseite (10.2) des Solarzellenstapels (10) erstreckt, stoffschlüssig und elektrisch leitfähig mit der Oberseite des Vorderseitenanschlusskontakts (26) verbunden ist und stoffschlüssig mit der dielektrischen Isolationsschicht (30) verbunden ist und
- der Rückseitenanschlusskontakt (34) einen nicht von der dielektrischen Isolationsschicht (30) bedeckten Bereich der Rückseite (10.2) des Solarzellenstapels (10) bedeckt und mit der Rückseite (10.2) des Solarzellenstapels (10) stoffschlüssig und elektrisch leitfähig verbunden ist.

2. Stapelförmige Mehrfachsolarzelle nach Anspruch 1, **dadurch gekennzeichnet, dass** die dielektrische Isolationsschicht (30) als eine Antireflexschicht ausgebildet ist.

3. Stapelförmige Mehrfachsolarzelle nach Anspruch 1, **dadurch gekennzeichnet, dass** die Mehrfachsolarzelle eine zwischen der dielektrischen Isolationsschicht (30) und dem Solarzellenstapel (10) angeordnete Antireflexschicht (28) aufweist, wobei die Antireflexschicht (28) den nicht von dem Vorderseitenanschluss (26) bedeckten Bereich der Vorderseite (10.1) des Solarzellenstapels (10) bedeckt.

4. Stapelförmige Mehrfachsolarzelle nach Anspruch 3, **dadurch gekennzeichnet, dass** die Antireflexschicht (28) den Randbereich der Oberseite des Vorderseitenanschlusskontakts (26) bedeckt.

5. Stapelförmige Mehrfachsolarzelle nach Anspruch 3 oder 4, **dadurch gekennzeichnet, dass** die Antireflexschicht (28) elektrisch leitfähig ist.

6. Stapelförmige Mehrfachsolarzelle nach einem der vorstehenden Ansprüche, **dadurch gekennzeichnet, dass** der Vorderseitenanschlusskontakt eine stoffschlüssig mit der Vorderseite (10.1) des Solarzellenstapels (10) verbundene hochdotierte Halbleiterkontaktschicht (26.1) und eine stoffschlüssig mit der Halbleiterkontaktschicht (26.1) verbundene Metallschicht (26.2) aufweist.

7. Stapelförmige Mehrfachsolarzelle (10) nach einem der vorstehenden Ansprüche, **dadurch gekennzeichnet, dass** die Durchgangskontaktöffnung (12) an der Vorderseite (10.1) der Mehrfachsolarzelle (10) einen ersten Durchmesser von mindestens 50 µm aufweist, wobei der erste Durchmesser nicht größer als 1 mm ist.

8. Stapelförmige Mehrfachsolarzelle (10) nach einem der vorstehenden Ansprüche, **dadurch gekennzeichnet, dass** ein Durchmesser der Durchgangskontaktöffnung (12) von der Vorderseite (10.1) zu der Rückseite (10.2) der Mehrfachsolarzelle (10) hin stufenförmig abnimmt, wobei eine erste Stufe von einer Oberseite der Ge-Tellzelle (16) und eine zweite Stufe von einem unterhalb eines pn-Übergangs (16.2) der Germanium-Tellzelle (16) befindlichen Bereich der Germanium-Teilzelle (16) ausgebildet ist und jede Stufe jeweils mit einer Auftrittstiefe umlaufend in die Durchgangskontaktöffnung (12) hineinragt.

9. Herstellungsverfahren für eine stapelförmige Mehrfachsolarzelle (1) mit rückseitenkontaktierter Vorderseite mindestens umfassend die Schritte:
- Bereitstellen einer Halbleiterscheibe (100) mit einer Oberseite (100.1), einer Unterseite (100.2) und umfassend mehrere Solarzellenstapel (10),
- wobei jeder Solarzellenstapel (10) ein die Unterseite (100.2) der Halbleiterscheibe (100) ausbildendes Ge-Substrat (14), eine Ge-Teilzelle (16) und mindestens zwei III-V-Teilzellen (18, 20) in der genannten Reihenfolge aufeinanderfolgen aufweist,
- Aufbringen eines Vorderseitenanschlusskontakts (26) auf der Oberseite (100.1) der Halbleiterscheibe (100) je Solarzellenstapel (10),
- Herstellen eines von der Oberseite (100.1) der Halbleiterscheibe (100) zumindest bis über einen pn-Übergang der Ge-Teilzelle in die Halbleiterscheibe hineinreichenden Grabens (40) mit zusammenhängender Seitenwand und einem im Querschnitt ovalen Umfang in einem Abstand zu dem Vorderseitenanschlusskontakt (26) je Solarzellenstapel (10),
- Herstellen eines von einem Boden des Grabens (40) bis zu der Unterseite (100.2) der Halbleiterscheibe (100) reichenden Durchgangslochs (42) mit zusammenhängender Seitenwand und einem im Querschnitt ovalen Umfang (12) je Solarzellenstapel (10),
- Aufbringen einer dielektrischen Isolationsschicht (30) entlang der Vorderseite (100.1) der Halbleiterscheibe (100), der Rückseite (100.2) der Halbleiterscheibe und auf der Seitenwand des Grabens (40) sowie der Seitenwand des Durchgangslochs (42),
- Entfernen der Isolationsschicht (30) auf einem Teil einer Oberseite des Vorderseitenanschlusskontakts (26) je Solarzellenstapel (10),
- Aufbringen einer von der freigelegten Oberseite des Vorderseitenanschlusskontakts (26) über die dielektrische Isolationsschicht (30) durch den Graben (40) und das Durchgangsloch (42) bis auf einen an das Durchgangsloch (42) angrenzenden mit der dielektrischen Isolationsschicht (30) beschichteten Bereich der Rückseite (100.2) der Halbleiterscheibe (100) reichenden Kontaktschicht je Solarzellenstapel (10), wobei
- je Solarzellenstapel ein Rückseitenanschlusskontakt (34) zu einem Zeitpunkt vor dem Aufbringen der dielektrischen Schicht auf der Rückseite (100.2) der Halbleiterscheibe (100) angeordnet und zu einem Zeitpunkt nach dem Aufbringen der dielektrischen Isolationsschicht (30) die dielektrische Isolationsschicht (30) auf einem Teil einer Oberseite des Rückseitenanschlusskontakts (34) entfernt wird oder
- je Solarzellenstapel zu einem Zeitpunkt nach dem Aufbringen der dielektrischen Isolationsschicht (34) die dielektrische Isolationsschicht (34) von einem Oberflächenabschnitt der Rückseite (100.2) der Halbleiterscheibe (100) entfernt und zu einem nachfolgenden Zeitpunkt ein Rückseitenanschlusskontakt (34) auf den freigelegten Oberflächenabschnitt der Rückseite (100.2) der Halbleiterscheibe (100) aufgebracht wird.

10. Herstellungsverfahren nach Anspruch 9, **dadurch gekennzeichnet, dass** vor dem Herstellen des Grabens (40) eine Antireflexschicht (28) auf einem nicht von den Vorderseitenanschlusskontakten (26) bedeckten Teil der Oberseite (100.1) der Halbleiterscheibe (100) aufgebracht wird und nach dem Entfernen der Isolationsschicht (30) auf einem Teil einer Oberseite des Vorderseitenanschlusskontakts (26) die Antireflexschicht (28) von dem Teil der Oberseite des Vorderseitenanschlusskontakts (26) entfernt wird.

11. Herstellungsverfahren nach Anspruch 9, **dadurch gekennzeichnet, dass** die dielektrische Isolationsschicht (30) als Antireflexschicht ausgebildet wird.

12. Herstellungsverfahren nach einem der Ansprüche 9 bis 11, **dadurch gekennzeichnet, dass** als Vorderseitenanschlusskontakt (26) erst eine hochdotierte Halbleiterkontaktschicht (26.1) auf der Vorderseite (100.1) der Halbleiterscheibe (100) und anschließend eine Metallschicht (26.2) auf einer Oberseite der hochdotierten Halbleiterkontaktschicht (26.1) aufgebracht werden.

13. Herstellungsverfahren nach einem der Ansprüche 9 bis 12, **dadurch gekennzeichnet, dass** der Vorderseitenanschlusskontakt (26) mittels mindestens eines Maskenprozesses aufgebracht wird.

14. Herstellungsverfahren nach einem der Ansprüche 9 bis 13, **dadurch gekennzeichnet, dass** der Graben (40) mittels eines Ätzprozesses erzeugt wird.

15. Herstellungsverfahren nach einem der Ansprüche 9 bis 14, **dadurch gekennzeichnet, dass** die dielektrische Isolationsschicht (30) von der Oberseite des Vorderseitenanschlusskontakts (26) und/oder von der Unterseite (100.2) der Halbleiterscheibe (100) mittels eines Laserablationsprozesses oder mittels eines Ätzprozesses entfernt wird.
